# EUROPÄISCHE PATENTSCHRIFT

(11) **EP 0 776 042 B1**
(45) Veröffentlichungstag und Bekanntmachung des Hinweises auf die Patenterteilung: **02.11.2005**
(21) Anmeldenummer: 96810750.8
(22) Anmeldetag: 07.11.1996
(51) Int. Cl.: H01L 25/07, H01L 23/538

(54) **Leistungshalbleitermodul mit einer Mehrzahl von Submodulen**
Power semiconductor module with a plurality of submodules
Module semi-conducteur à haute puissance avec une pluralité de sous-modules

(30) Priorität: 24.11.1995 US 562454
(43) Veröffentlichungstag der Anmeldung: 28.05.1997
(73) Patentinhaber: ABB Schweiz AG, 5400 Baden (CH)
(72) Erfinder: Bayerer, Reinhold, Dr., 64385 Reichelsheim (DE)
(74) Vertreter: ABB Patent Attorneys

(56) Entgegenhaltungen:
- EP-A- 0 597 144
- DE-A- 3 516 995
- DE-A- 3 937 045
- DE-A- 4 130 160
- US-A- 5 347 158

## Beschreibung

### TECHNISCHES GEBIET

Die vorliegende Erfindung bezieht sich auf das Gebiet der Leistungselektronik. Sie betrifft ein Leistungshalbleitermodul mit einer Mehrzahl von Submodulen, welche nebeneinander auf einer gemeinsamen Bodenplatte angeordnet und auf der Leistungsseite induktionsarm durch plattenförmige Leiter untereinander elektrisch verbunden und von aussen anschliessbar sind.

### STAND DER TECHNIK

Ein solches Leistungshalbleitermodul ist z. B. aus der EP-A1-0 597 144 bekannt.

Hybrid aufgebaute Leistungshalbleitermodule, bei denen auf einer gemeinsamen Grundplatte und in einem gemeinsamen Gehäuse eine Mehrzahl von Einzelhalbleitern in Chip-Form nebeneinander angeordnet und untereinander verbunden sind, sind seit langem bekannt (siehe auch die DE-PS-36 69 017).

Bei einem derartigen Modulaufbau sind verschiedene Anforderungen zu erfüllen. Zum einen müssen die Einzelhalbleiter zur guten Kühlung bei hohen Leistungen thermisch eng an die Aussenseiten des Gehäuses angekoppelt sein. Zum anderen müssen die elektrischen Verbindungen innerhalb des Gehäuses und nach draussen für den Leistungsteil hohe Ströme tragen können und zugleich gegeneinander ausreichend beabstandet oder isoliert sein, um die teilweise hohen Potentialdifferenzen ohne Spannungsüberschläge bewältigen zu können. Weiterhin soll der Auf- und Zusammenbau des Moduls möglichst einfach und kostensparend sein. Schliesslich wird es bei modernen schnellen Leistungshalbleitern mit kleinen Schaltzeiten, wie sie z.B. die IGBTs (Insulated Gate Bipolar Transistors) darstellen, zunehmend wichtig, die elektrischen Verbindungen und Anschlüsse induktionsarm auszuführen, um die grundsätzlich möglichen hohen Stromanstiegszeiten der Halbleiterbaulemente im Modul ausnützen zu können.

Um diese Anforderungen erfüllen zu können, ist in der eingangs genannten Druckschrift bereits eine hybride leistungselektronische Anordnung vorgeschlagen worden, bei der zur Verbindung der Submodule untereinander und zum Anschluss nach aussen eine Stapelanordnung aus abwechselnd übereinander geschichteten Isoliermaterialschichten und Leiterbahnschichten verwendet wird. Mit dieser Lösung lassen sich bei einfachem und kostengünstigem Aufbau und guter Funktionssicherheit sehr induktivitätsarme Module realisieren.

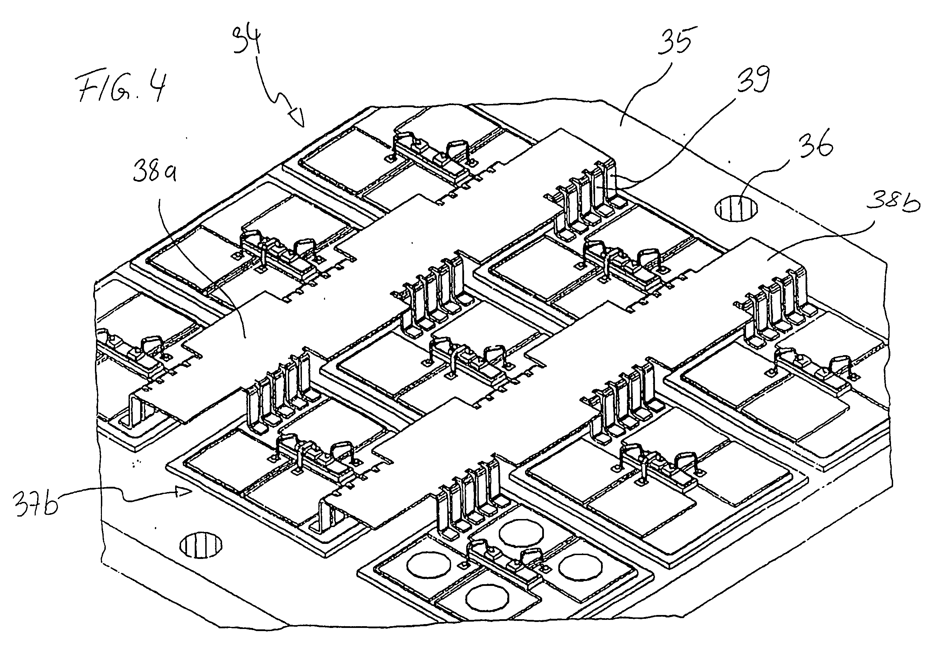

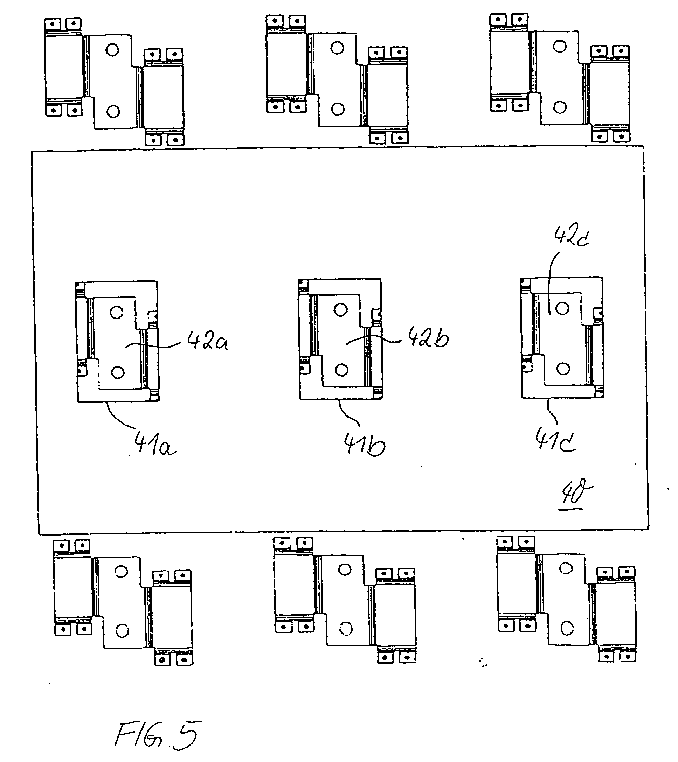

Gleichwohl ist dieser bekannte Modulaufbau nicht ohne Probleme: im Bereich der Submodule sind nämlich die Isolier- und Leiterlagen ausgespart, um eine Bondierung der Submodule zur Umgebung zu ermöglichen (Fig. 4, 5). Die Isolier- und Leiterlagen sind deshalb in Form einer Gitterstruktur ausgebildet, wobei die Stege der Struktur zwischen den Submodulen zu liegen kommen. Eine Folge davon ist, dass für die plattenförmige Verdrahtung zusätzliche Fläche bereitgestellt werden muss. Aus diesem Grund benötigen Module dieser Art grössere Flächen als andere Module, deren Anschlüsse üblicherweise senkrecht von den Submodulen aus nach oben gehen und zum Anschluss auf der Moduloberseite führen.

US 5,347,158 beschreibt ein Halbleitermodul mit einer Mehrzahl von Halbleiterelementen. Auf einer Bodenplatte sind Halbleiterelemente in zwei Reihen angeordnet. Die Halbleiterelemente einer Reihe werden leistungsseitig mit den Halbleiterelementen einer benachbarten Reihe mittels u-förmiger Verbindungsstücke elektrisch leitend verbunden. Die Leistungszuführung erfolgt über Leitungselemente, die senkrecht zur Bodenplatte in einer Ebene angeordnet sind.

DE 41 30 160 A1 zeigt ein Leistungshalbleitermodul mit einer Mehrzahl von Halbleiterelementen, die auf einer isolierenden Bodenplatte angeordnet sind, und Anschlussleitern, wobei die Anschlussleiter Kontakte zwischen Halbleiterelement und Kontaktflächen oder zwischen Kontaktflächen untereinander schaffen. Ausserdem dienen die Anschlussleiter als äussere Anschlüsse. Die Anschlussleiter sind entweder parallel oder senkrecht zu der isolierenden Bodenplatte angeordnet.

### DARSTELLUNG DER ERFINDUNG

Es ist daher Aufgabe der Erfindung, ein Leistungshalbleitermodul zu schaffen, bei welchem unter Beibehaltung des Vorteils der geringen inneren Induktivität sowie des breiten niederinduktiven Anschlusses nach aussen der Nachteil eines Flächenverlustes vermieden wird.

Die Aufgabe wird bei einem Leistungshalbleitermodul der eingangs genannten Art durch die kennzeichnenden Merkmale des Anspruchs 1 gelöst.

Ein Modul nach der Erfindung ist also dadurch gekennzeichnet, dass die zwischen der Bodenplatte und dem am weitesten von der Bodenplatte entfernt liegenden, mittleren der plattenförmigen Leiter mit Durchbrüchen versehen sind, durch welche die vertikalen Leitungselemente für die Verbindung von den Submodulen zu den darüberliegenden plattenförmigen Leitern hindurchgeführt sind. Hierdurch wird ein einfacher Aufbau erreicht, der induktionsarm und zugleich platzsparend ist.

Eine erste bevorzugte Ausführungsform des erfindungsgemässen Leistungshalbleitermoduls zeichnet sich dadurch aus, dass die vertikalen Leitungselemente aus mehrfach, vorzugsweise rechtwinklig gebogenen Blechstreifen bestehen, und dass die vertikalen Leitungselemente derart gebogen sind, dass sie eine thermisch bedingte Ausdehnung der Submodule bzw. der Bodenplatte parallel zur Ebene der Bodenplatte ausgleichen können. Hierdurch wird bei geringer Induktivität eine hohe Wechsellastfestigkeit erreicht. Zugleich lassen sich durch den Einsatz der Blechstreifen sämtliche Verbindungen zwischen den Submodulen und den äusseren Anschlüssen als Lötverbindungen ausführen, so dass gemäss einer Weiterbildung dieser Ausführungsform die vertikalen Leitungselemente mit den plattenförmigen Leitern und den Submodulen verlötet sind.

Teilentladungsprobleme zwischen den auf verschiedenem Potential liegenden plattenförmigen Leitern werden dadurch sicher vermieden, wenn gemäss einer weiteren Ausführungsform die Submodule mit den zugehörigen plattenförmigen Leitern und vertikalen Leitungselementen in einem Gehäuse angeordnet und mit einer elektrisch isolierenden Masse vergossen sind.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in perspektivischer Ansicht ein Ausführungsbeispiel für ein Submodul, welches in einem Leistungshalbleitermodul nach der Erfindung Verwendung findet;
- Fig. 2: das Submodul aus Fig. 1 mit einem vertikalen Leitungselement in Form eines Emitter-Clip;
- Fig. 3: in der Draufsicht ein Ausführungsbeispiel eines erfindungsgemässen Leistungshalbleitermoduls mit 9 auf einer Bodenplatte angeordneten Submodulen (ohne Leistungsverbindungen und Anschlüsse);
- Fig. 4: in perspektivischer Ansicht das Modul aus Fig. 3 mit vertikalen Leitungselementen in Form von Kollektor-Clips;
- Fig. 5: in der Draufsicht die Anordnung der Emitter-Clips für ein Modul nach Fig. 3 bzw. 4 und einer beispielhaften Kollektorplatte zur Verbindung mit den Kollektor-Clips aus Fig. 4;
- Fig. 6: in der Draufsicht die Anordnung aus Fig. 5 mit einer zusätzlichen beispielhaften Emitterplatte, welche die Kollektorplatte teilweise überdeckt und mit den Emitter-Clips verbunden ist; und
- Fig. 7: in einer schematischen Seitenansicht die Anordnung der Emitter-Clips, der Kollektor-Clips, der Kollektorplatte und der Emitterplatte eines Moduls gemäss Fig. 6.

### WEGE ZUR AUSFÜHRUNG DER ERFINDUNG

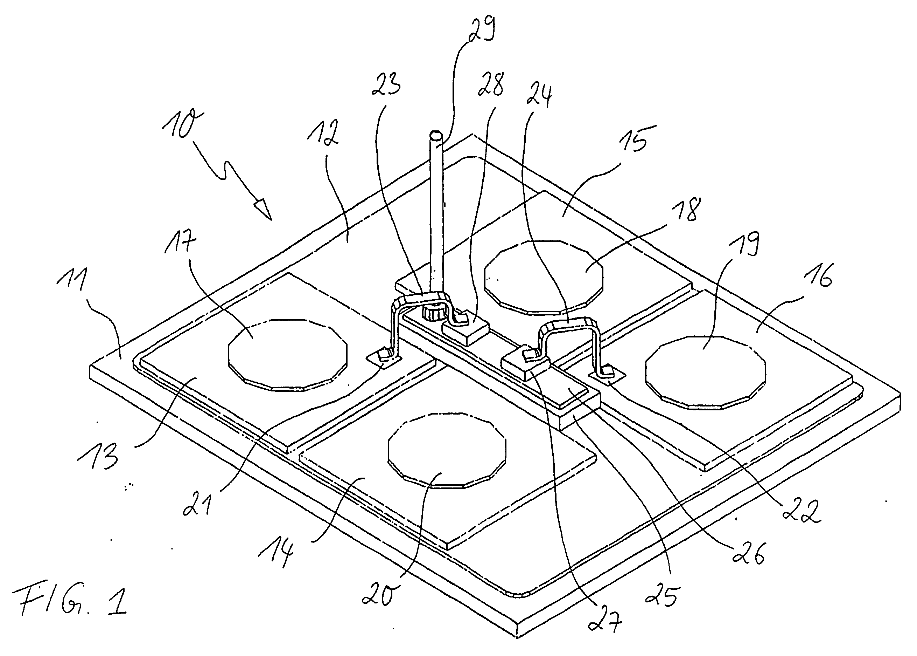

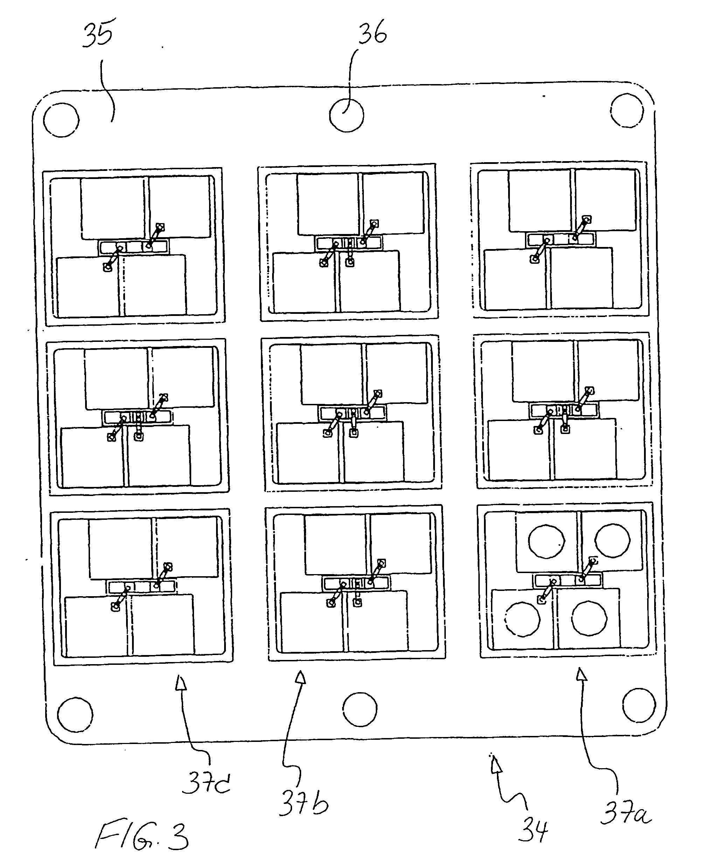

In Fig. 3 ist das Grundschema eines Ausführungsbeispiels für ein Leistungshalbleitermodul 34 nach der Erfindung in der Draufsicht dargestellt. Auf einer gemeinsamen Bodenplatte 35, die am Rande mit Befestigungslöchern 36 ausgestattet ist, ist eine Mehrzahl von - in diesem Beispiel neun - Submodulen dicht gepackt nebeneinander angeordnet. Der Einfachheit halber sind nur die drei untersten Submodule mit Bezugszeichen 37a, 37b und 37c versehen. Der Aufbau eines einzelnen Submoduls ist beispielhaft in Fig. 1 wiedergegeben. Das Submodul 10 umfasst ein (keramisches) Substrat 11, welches auf einer Seite (der Oberseite) mit einer grossflächigen Metallisierung 12 bedeckt ist. Die Metallisierung 12 ist durchgehend und weist keine Leiterbahnstrukturen auf. Sie dient zur Aufnahme der Leistungshalbleiterchips und der Laschen für die unterseitige Chipkontaktierung.

Im Beispiel der Fig. 1 sind auf dem Substrat 11 zwei IGBTs 13, 16 und zwei Dioden 14, 15 untergebracht. Der Kollektor der IGBTs 13, 16 befindet sich auf der Unterseite der zugehörigen Chips und kann über die lötbare Metallisierung 12 des Submoduls 10 angeschlossen werden. Dazu sind neben den Dioden 14, 15 jeweils Flächen auf der Metallisierung 12 freigelassen, auf die entsprechende vertikale Leitungselemente aufgelötet werden können ((Fig. 4). Dasselbe gilt für die Kathoden der Dioden 14, 15. Auf den Oberseiten der Chips sind bei den IGBTs 13, 16 die Emitter, und bei den Dioden 14, 15 die Anoden angeordnet. Zu Anschlusszwecken ist jeweils eine Metallscheibe 17, 19 bzw. 18, 20 aufgelötet (In Fig. 3 sind nur die Metallscheiben des Submoduls 37a eingezeichnet). Die Gates 21, 22 der IGBTs 13, 16 befinden sich ebenfalls auf der Oberseite der Chips. Sie sind über gelötete Gate-Clips 23, 24 mit entsprechenden Gatewiderständen 27, 28 verbunden, die auf einem gemeinsamen Gateblock oder Gaterunner 25 angeordnet sind und dort zusammenlaufen. Der längliche Gaterunner 25 liegt zwischen den Chips ebenfalls auf dem Substrat 11 des Submoduls und besteht aus einem mit einer Metallisierung 26 bedeckten Substrat. Der Anschluss der Gates 21, 22 wird vom Gaterunner 25 aus mit einem aufgelöteten Anschlussdraht 29 nach oben geführt.

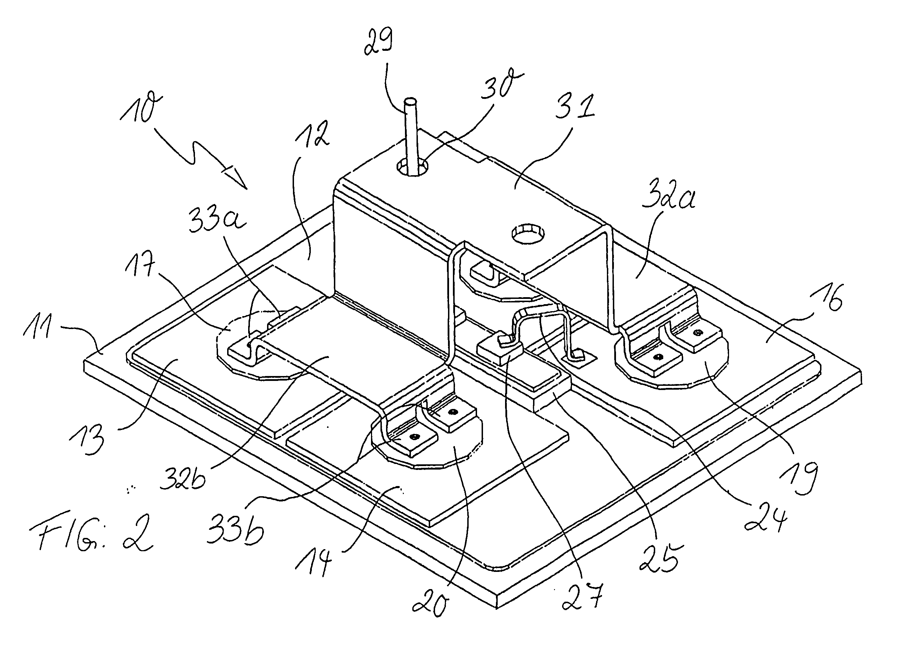

Alle IGBT-Emitter und Dioden-Anoden eines Submoduls sind untereinander kurzgeschlossen und gemeinsam zu Anschlusszwecken nach oben geführt. Dazu ist gemäss Fig. 2 pro Submodul 10 ein Emitter-Clip 31 vorgesehen. Der Emitter-Clip 31 besteht aus einem Blechstreifen, der U-förmig gebogen ist. Die Schenkel des U-förmigen Grundkörpers sind an ihren Enden rechtwinklig nach aussen abgebogen und gehen jeweils in eine horizontal liegende erste Lasche 32a,b über. Die Abmessungen sind dabei so gewählt, dass das auf dem Kopf stehende U den Gaterunner 25 und die Gate-Clips 23, 24 frei überspannt und die ersten Laschen 32a,b jeweils zwischen den Metallscheiben 17 und 20 bzw. 18 und 19 eines IGBTs 13 bzw. 16 und der benachbarten Diode 14 bzw. 15 verlaufen. An den Querseiten der ersten Laschen 32a,b sind durch zweifaches rechtwinkliges Abbiegen zweite Laschen 33a,b gebildet, mit denen der Emitter-Clip 31 auf die Metallscheiben 17-20 der Halbleiterchips aufgelötet ist.

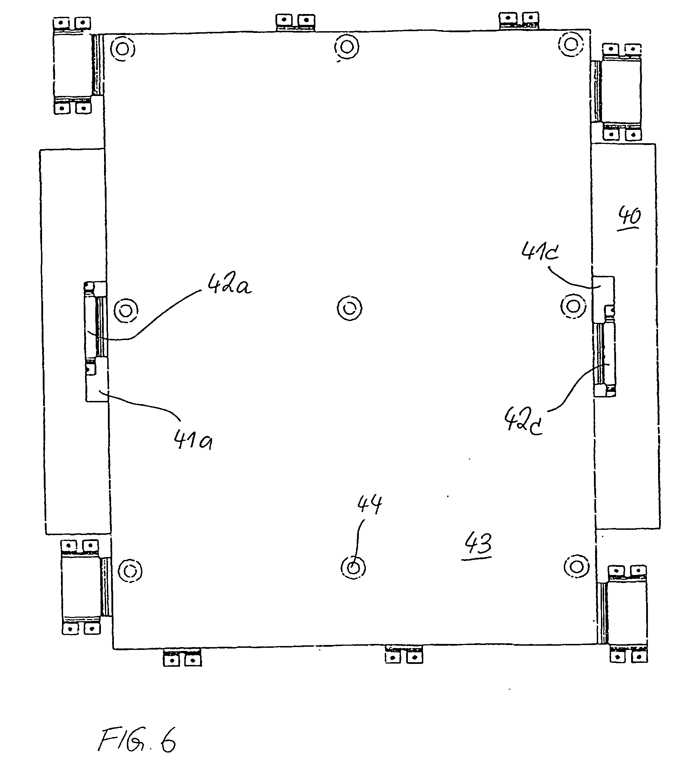

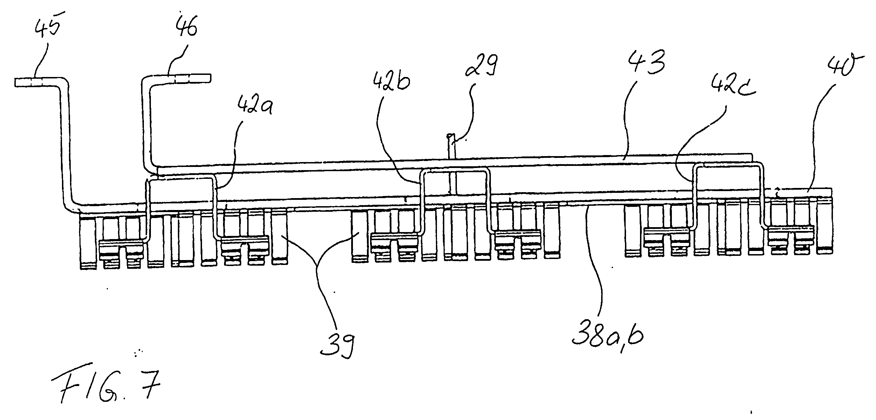

Mit Hilfe des Emitter-Clips 31 entsteht über den Submodulen ein höhergelegenes Niveau für den Anschluss (die Verlötung) der Emitter/Anoden mit einem Sammelblech (Emitterplatte 43 in Fig. 6, 7), d.h. einer darüber angeordneten Emitterlage. Durch das Abbiegen der ersten und zweiten Laschen 32a,b und 33a,b in zueinander senkrecht stehenden Richtungen entstehen Biege/Dehnungsbögen, die es erlauben, die unterschiedlichsten thermischen Ausdehnungen der Clips, der Keramik, der Halbleiterchips und der anderen Bauteile des Moduls in zwei zueinander senkrechten stehenden Richtungen auszugleichen. Die auf den Gaterunner 25 aufgelöteten Gate-Clips 23, 24 sind aufgrund ihrer geringen Breite und ihrer Länge in allen Richtungen leicht biegbar.

Der Anschluss der Kollektoren/Kathoden und deren Verbindung mit einer höhergelegenen Kollektorebene erfolgt gemäss Fig. 4 über Kollektor-Clips 38a,b. Die Kollektor-Clips 38a,b bestehen aus länglichen Blechstreifen, an deren Längsseiten alternierend Gruppen von dritten Laschen 39 zweifach rechtwinklig abgebogen sind. Die dritten Laschen 39 bilden Lötfüsse, mit denen die Kollektor-Clips 38a,b auf die freien Flächen der Metallisierung der einzelnen Submodule gelötet sind. Durch das Abbiegen der dritten Laschen 39 und die Unterteilung in schmale Segmente ist auch bei den Kollektor-Clips 38a,b gewährleistet, dass thermische Ausdehnungen in zwei unabhängigen Raumrichtungen zuverlässig ausgeglichen werden.

Die Kollektor-Clips 38a,b sind jeweils zwischen zwei Dreierreihen von Submodulen angeordnet und verbinden diese Dreierreihen untereinander. Sie sind untereinander auf der höhergelegenen Kollektorebene gemäss Fig. 5 mittels einer Kollektorplatte 40 verbunden, die auf den Kollektor-Clips 38a,b aufliegt und mit diesen verlötet ist. Da die Kollektorebene tiefer liegt als die Emitterebene, sind in der Kollektorplatte 40 Durchbrüche 41a-c vorgesehen, durch welche hindurch die Emitter-Clips 42a-c der darunterliegenden Submodule in die höhergelegene Emitterebene reichen können. Die neun Emitter-Clips (Fig. 5) der neun Submodule werden auf der Emitterebene gemäss Fig. 6 mittels einer durchgehenden Emitterplatte 43 verbunden, die auf den Emitter-Clips aufliegt und mit diesen verlötet ist.

Der Aufbau der Verbindungen und Anschlüsse mit den verschiedenen Ebenen ist besonders gut in der Seitenansicht der Fig. 7 zu sehen. Das Plattenpaket 40, 43 besteht nicht - wie bei dem bekannten Modul aus der eingangs zitierten Druckschrift - aus Isolier- und Metallagen, sondern nur aus Metallagen. Diese Metallagen sind über den Submodulen angeordnet. Die Metallagen haben untereinander und zu den Submodulen ausreichend vertikalen Abstand, um nach dem Vergiessen eine hinreichend grosse Spannung isolieren zu können. Da Isolierlagen vermieden werden, sind auch die mit der zugehörigen Klebetechnik verbundenen Teilentladungsprobleme vermieden. Der offene Metallstapel 40, 43 wird (in einem Gehäuse) vergossen und vor dem Aushärten des Vergusses evakuiert, damit jegliche Luftblasen vermieden werden und der Stapel teilentladungsfrei wird. Durch die spezielle Ausgestaltung der vertikalen Verbindungselemente 31, 38a,b und 42a,b mit ihren Biege/Dehnungsbögen und den verschiedenen laschen 32a,b, 33a,b und 39 ist sichergestellt, dass die Lötstellen zwischen den Platten 40, 43 und den Submodulen quasi frei von mechanischen Spannungen bleiben und keine Alterung durchmachen.

Der Anschluss der IGBT-Gates erfolgt - wie bereits erwähnt - über nach oben geführte Anschlussdrähte 29. Zu diesem Zweck sind sowohl in den einzelnen Emitter-Clips 31 als auch in der Emitterplatte 43 Durchgangslöcher 30 (Fig. 2) bzw. Gatedurchführungen 44 (Fig. 6) vorgesehen. Der äussere Anschluss der Emitter und Kollektoren erfolgt gemäss Fig. 7 zweckmässigerweise über Aussenanschlüsse 45, 46, die an der Kollektorplatte 40 bzw. der Emitterplatte 43 angeformt sind.

Insgesamt ergibt sich mit der Erfindung ein Leistungshalbleitermodul, dass bei geringer Induktivität m Inneren und den Zuleitungen wenig Platz beansprucht, leicht aufzubauen ist und eine hohe Wechsellastfestigkeit aufweist.

### BEZEICHNUNGSLISTE

- 10: Submodul
- 11: Substrat
- 12: Metallisierung
- 13,16: IGBT
- 14,15: Diode
- 17-20: Metallscheibe
- 21,22: Gate (IGBT)
- 23,24: Gate-Clip
- 25: Gaterunner
- 26: Metallisierung (Gaterunner)
- 27,28: Gatewiderstand
- 29: Anschlussdraht (Gate)
- 30: Durchgangsloch
- 31: Emitter-Clip
- 32a,b: Lasche (Dehnungsausgleich in y-Richtung)
- 33a,b: Lasche (Dehnungsausgleich in x-Richtung)
- 34: Leistungshalbleitermodul
- 35: Bodenplatte
- 36: Befestigungsloch
- 37a-c: Submodul
- 38a,b: Kollektor-Clip
- 39: Lasche
- 40: Kollektorplatte
- 41a-c: Durchbruch (Emitter-Clip)
- 42a-c: Emitter-Clip
- 43: Emitterplatte
- 44: Gatedurchführung
- 45,46: Aussenanschluss

## Patentansprüche

1. Leistungshalbleitermodul (34) mit einer Mehrzahl von Submodulen (10, 37a-c), welche nebeneinander auf einer gemeinsamen Bodenplatte (35) angeordnet sind,
mit plattenförmigen Leitern (40, 43), welche jeweils auf unterschiedlichen, parallel zueinander und zur Bodenplatte gelegenen Ebenen freitragend oberhalb der Submodule (10, 37a-c) angeordnet sind,
welche Ebenen untereinander und von den Submodulen (10, 37a-c) einen für die elektrische Isolierung ausreichenden vertikalen Abstand aufweisen,
wobei die Submodule (10, 37a-c) auf der Leistungsseite induktionsarm durch die plattenförmige Leiter (40, 43) elektrisch verbunden und von aussen anschliessbar sind, und
mit vertikalen Leitungselementen (31, 38 a, b, 42 a - c), über welche die einzelnen Submodule (31, 38 a, b, 42 a - c) und die plattenförmigen Leiter (40, 43) elektrisch verbunden sind,
**dadurch gekennzeichnet, dass**
ein plattenförmiger Leiter (40), welcher zwischen der Bodenplatte (35) und dem am weitesten von der Bodenplatte (35) entfernt liegenden plattenförmigen Leiter (43) angeordnet ist, mit Durchbrüchen (41a-c) versehen ist, durch welche die vertikalen Leitungselemente (31, 42a-c) für die Verbindung von den Submodulen (10, 37a-c) zu dem am weitesten von der Bodenplatte (35) entfernt liegenden plattenförmigen Leiter (43) hindurchgeführt sind.

2. Leistungshalbleitermodul nach Anspruch 1, **dadurch gekennzeichnet, dass** die vertikalen Leitungselemente (31, 38a,b, 42a-c) aus mehrfach, vorzugsweise rechtwinklig gebogenen Blechstreifen bestehen.

3. Leistungshalbleitermodul nach Anspruch 2, **dadurch gekennzeichnet, dass** die vertikalen Leitungselemente (31, 38a,b, 42a-c) derart gebogen sind, dass sie eine thermisch bedingte Ausdehnung der Submodule (10, 37a-c) bzw. der Bodenplatte (35) parallel zur Ebene der Bodenplatte (35) ausgleichen können.

4. Leistungshalbleitermodul nach Anspruch 1, **dadurch gekennzeichnet, dass** zumindest einer der plattenförmigen Leiter (40, 43) eine Fläche aufweist, welche einen Grossteil der von den Submodulen (10, 37a-c) belegten Fläche überdeckt.

5. Leistungshalbleitermodul nach einem der Ansprüche 1 oder 4, **dadurch gekennzeichnet, dass** die plattenförmigen Leiter (40, 43) sich zumindest teilweise überlappen und Durchbrüche (41a-c) in diesen Überlappungsbereichen angeordnet sind.

6. Leistungshalbleitermodul nach Anspruch 1, **dadurch gekennzeichnet, dass** Aussenanschlüsse (45, 46), über welche die Submodule (10, 37a-c) von aussen elektrisch anschliessbar sind, an die plattenförmigen Leiter (40, 43) angeformt sind.

7. Leistungshalbleitermodul nach einem der Ansprüche 1 bis 6, **dadurch gekennzeichnet, dass** die Submodule (10, 37a-c) mit den zugehörigen plattenförmigen Leitern (40, 43) und vertikalen Leitungselementen (31, 38a,b, 42a-c) in einem Gehäuse angeordnet und mit einer elektrisch isolierenden Masse vergossen sind.

8. Leistungshalbleitermodul nach einem der Ansprüche 1 bis 7, **dadurch gekennzeichnet, dass** jedes Submodul (10, 37a-c) ein isolierendes, vorzugsweise aus einer Keramik bestehendes Substrat (11) aufweist, welches auf der Oberseite mit einer Metallisierung (12) versehen ist, und dass auf der Metallisierung (12) eine Mehrzahl von Leistungshalbleitern (13, 14, 15, 16) in Chip-Form angeordnet und auf ihrer Unterseite mit der Metallisierung (12) elektrisch leitend verbunden sind.

9. Leistungshalbleitermodul nach Anspruch 8, **dadurch gekennzeichnet, dass** wenigstens zwei der Leistungshalbleiter (13, 14, 15, 16) eines Submoduls (10, 37a-c) jeweils über ein Gate (21, 22) steuerbar sind, und dass die Gates (21, 22) an einen gemeinsamen Gateblock oder Gaterunner (25) angeschlossen sind, welcher zwischen den Leistungshalbleitern (13, 14, 15, 16) auf dem Substrat (11, 12) angeordnet und von aussen anschliessbar ist.

10. Leistungshalbleitermodul nach Anspruch 9, **dadurch gekennzeichnet, dass** der Anschluss der Gates (21, 22) an den Gateblock oder Gaterunner (25) über einzelne, auf dem Gateblock oder Gaterunner (25) angeordnete Gatewiderstände (28, 29) erfolgt.

11. Leistungshalbleitermodul nach einem der Ansprüche 9 und 10, **dadurch gekennzeichnet, dass** die über ein Gate (21, 22) steuerbaren Leistungshalbleiter (13, 16) als IGBTs (Insulated Gate Bipolar Transistors) und die übrigen Leistungshalbleiter als Dioden (14, 15) ausgebildet sind.

## Claims

1. Power semiconductor module (34) having a plurality of submodules (10, 37a-c), which are arranged next to one another on a common baseplate (35),
having conductors (40, 43) in the form of plates which are each arranged in a self-supporting manner above the submodules (10, 37a-c) on different planes located parallel to one another and to the baseplate,
which planes have a vertical separation from one another and from the submodules (10, 37a-c) which is sufficient for electrical insulation,
the submodules (10, 37a-c) being electrically connected, and being able to be externally connected, on the power side in a low-inductance manner by means of the conductors (40, 43) in the form of plates, and
having vertical conduction elements (31, 38a, b, 42a-c) via which the individual submodules (10, 37a-c) and the conductors (40, 43) in the form of plates are electrically connected,
**characterized in that**
a conductor (40) in the form of a plate which is arranged between the baseplate (35) and the conductor (43) in the form of a plate which is situated the furthest away from the baseplate (35) is provided with perforations (41a-c) through which are routed the vertical conduction elements (31, 42a-c) for the connection of the submodules (10, 37a-c) to the conductor (43) in the form of a plate which is situated the furthest away from the baseplate (35).

2. Power semiconductor module according to Claim 1, **characterized in that** the vertical conduction elements (31, 38a, b, 42a-c) consist of sheet-metal strips which are bent more than once, preferably at right angles.

3. Power semiconductor module according to Claim 2, **characterized in that** the vertical conduction elements (31, 38a, b, 42a-c) are bent in such a way that they can compensate for a thermally induced expansion of the submodules (10, 37a-c) and/or of the baseplate (35) parallel to the plane of the baseplate (35).

4. Power semiconductor module according to Claim 1, **characterized in that** at least one of the conductors (40, 43) in the form of plates has an area which covers a large part of the area occupied by the submodules (10, 37a-c).

5. Power semiconductor module according to either of Claims 1 and 4, **characterized in that** the conductors (40, 43) in the form of plates at least party overlap and perforations (41a-c) are arranged in these overlap regions.

6. Power semiconductor module according to Claim 1, **characterized in that** external connections (45, 46) via which the submodules (10, 37a-c) can be electrically connected externally, are integrally formed on the conductors (40, 43) in the form of plates.

7. Power semiconductor module according to one of Claims 1 to 6, **characterized in that** the submodules (10, 37a-c) together with the associated conductors (40, 43) in the form of plates and the vertical conduction elements (31, 38a, b, 42a-c) are arranged in a housing and are potted with an electrically insulating compound.

8. Power semiconductor module according to one of Claims 1 to 7, **characterized in that** each submodule (10, 37a-c) has an insulating substrate (11), which preferably comprises a ceramic and is provided with a metallization layer (12) on the top side, and **in that** a plurality of power semiconductors (13, 14, 15, 16) in chip form are arranged on the metallization layer (12) and are electrically conductively connected to the metallization layer (12) on their underside.

9. Power semiconductor module according to Claim 8, **characterized in that** at least two of the power semiconductors (13, 14, 15, 16) of a submodule (10, 37a-c) can in each case be controlled via a gate (21, 22), and **in that** the gates (21, 22) are connected to a common gate block or gate runner (25) which is arranged between the power semiconductors (13, 14, 15, 16) on the substrate (11, 12) and can be externally connected.

10. Power semiconductor module according to Claim 9, **characterized in that** the connection of the gates (21, 22) to the gate block or gate runner (25) takes place via individual gate resistors (28, 29) arranged on the gate block or gate runner (25).

11. Power semiconductor module according to either of Claims 9 and 10, **characterized in that** the power semiconductors (13, 16) which can be controlled via a gate (21, 22) are designed as IGBTs (Insulated Gate Bipolar Transistors) and the remaining power semiconductors are designed as diodes (14, 15).

## Revendications

1. Module semi-conducteur de puissance (34) avec une pluralité de sous-modules (10, 37a-c) qui sont agencés les uns à côté des autres sur une plaquette de fond commune (35),
avec des conducteurs en forme de plaques (40, 43) qui sont agencés en porte-à-faux sur différents plans parallèles entre eux et par rapport à la plaquette de fond, au dessus des sous-modules (10, 37a-c),
lesquels plans présentent entre eux et par rapport aux sous-modules (10, 37a-c) une distance verticale suffisante pour l'isolation électrique,
les sous-modules (10, 37a-c) étant reliés électriquement avec une faible induction du côté puissance par les conducteurs en forme de plaques (40, 43) et pouvant être connectés de l'extérieur, et
avec des éléments conducteurs verticaux (31, 38a,b, 42a-c) par lesquels les différents sous-modules (10, 37a-c) et les conducteurs en forme de plaques (40, 43) sont reliés électriquement,
**caractérisé**
**en ce qu'**un conducteur en forme de plaque (40), qui est agencé entre la plaquette de fond (35) et le conducteur en forme de plaque (43) le plus éloigné de la plaquette de fond (35), est doté de trous (41a-c) à travers lesquels sont insérés les éléments conducteurs verticaux (31, 42a-c) pour la liaison des sous-modules (10, 37a-c) au conducteur en forme de plaque (43) le plus éloigné de la plaquette de fond (35).

2. Module semi-conducteur de puissance selon la revendication 1, **caractérisé en ce que** les éléments conducteurs verticaux (31, 38a,b, 42a-c) sont constitués de bandes de tôle pliées plusieurs fois, de préférence à angle droit.

3. Module semi-conducteur de puissance selon la revendication 2, **caractérisé en ce que** les éléments conducteurs verticaux (31, 38a,b, 42a-c) sont pliés de telle sorte qu'ils peuvent compenser une dilatation d'origine thermique des sous-modules (10, 37a-c) ou selon le cas de la plaquette de fond (35) parallèlement au plan de la plaquette de fond (35).

4. Module semi-conducteur de puissance selon la revendication 1, **caractérisé en ce qu'**au moins un des conducteurs en forme de plaques (40, 43) présente une surface qui recouvre une grande partie de la surface occupée par les sous-modules (10, 37a-c).

5. Module semi-conducteur de puissance selon la revendication 1 ou 4, **caractérisé en ce que** les conducteurs en forme de plaques (40, 43) se chevauchent au moins partiellement et **en ce que** des trous (41a-c) sont agencés dans ces zones de chevauchement.

6. Module semi-conducteur de puissance selon la revendication 1, **caractérisé en ce que** des connexions extérieures (45, 46) par lesquelles les sous-modules (10, 37a-c) peuvent être connectés électriquement de l'extérieur sont formées sur les conducteurs en forme de plaques (40, 43).

7. Module semi-conducteur de puissance selon l'une quelconque des revendications 1 à 6, **caractérisé en ce que** les sous-modules (10, 37a-c) sont agencés dans un boîtier avec les conducteurs en forme de plaques (40, 43) et les éléments conducteurs verticaux (31, 38a,b, 42a-c) correspondants, et encapsulés avec une masse électriquement isolante.

8. Module semi-conducteur de puissance selon l'une quelconque des revendications 1 à 7, **caractérisé en ce que** chaque sous-module (10, 37a-c) présente un substrat (11) isolant constitué de préférence de céramique qui est doté sur la face supérieure d'une métallisation (12), et **en ce que** sur la métallisation (12), une pluralité de semi-conducteurs de puissance (13, 14, 15, 16) sous forme de puces sont agencés et reliés de manière électro-conductrice sur leur face inférieure avec la métallisation (12).

9. Module semi-conducteur de puissance selon la revendication 8, **caractérisé en ce qu'**au moins deux des semi-conducteurs de puissance (13, 14, 15, 16) d'un sous-module (10, 37a-c) sont réglables chacun par une grille (21, 22), et **en ce que** les grilles (21, 22) sont connectées à un bloc de grilles ou gaterunner (25) commun qui est agencé entre les semi-conducteurs de puissance (13, 14, 15, 16) sur le substrat (11, 12) et peut être connecté de l'extérieur.

10. Module semi-conducteur de puissance selon la revendication 9, **caractérisé en ce que** la connexion des grilles (21, 22) au bloc de grilles ou gaterunner (25) se fait par différentes résistances de grille (28, 29) agencées sur le bloc de grilles ou gaterunner (25).

11. Module semi-conducteur de puissance selon la revendication 9 ou 10, **caractérisé en ce que** les semi-conducteurs de puissance (13, 16) réglables par une grille (21, 22) sont configurés comme des IGBT (Insulated Gate Bipolar Transistors) et les autres semi-conducteurs de puissance (14, 15) comme des diodes.
